# EUROPÄISCHE PATENTANMELDUNG

(11) **EP 2 164 174 A2**
(43) Veröffentlichungstag der Anmeldung: **17.03.2010**
(21) Anmeldenummer: 09168721.0
(22) Anmeldetag: 26.08.2009
(51) Int. Cl.: H03K 19/003, H01L 23/34

(54) **Verfahren und Schaltungsanordnung zur Erhöhung der Spannungsfestigkeit von Metalloxidtransistoren bei niedrigen Temperaturen**

(30) Priorität: 11.09.2008 DE 102008046734
(71) Anmelder: Osram Gesellschaft mit beschränkter Haftung, 81536 München (DE)
(72) Erfinder: Mühlschlegel, Joachim, 82194, Gröbenzell (DE)

(57) **Zusammenfassung**

Die Erfindung betrifft ein Verfahren zur Erhöhung der Spannungsfestigkeit einer elektronischen Schaltungsanordnung bei niedrigen Temperaturen, wobei die Schaltungsanordnung mindestens einen Metalloxidtransistor aufweist, und vor dem Anlegen einer Spannung, die in der Nähe der Durchbruchsspannung der Metalloxidtransistoren liegt, diese durch geeignete Maßnahmen auf eine vorbestimmte Temperatur aufgeheizt werden.

Die Erfindung betrifft ebenfalls eine Schaltungsanordnung mit einer erhöhten Spannungsfestigkeit bei niedrigen Temperaturen, wobei die Schaltungsanordnung mindestens einen Metalloxidtransistor aufweist, und der mindestens eine Metalloxidtransistor aufgeheizt wird, bevor eine Spannung, die in der Nähe der Sperrspannung des Metalloxidtransistors liegt, an ihn angelegt wird.

## Beschreibung

### Technisches Gebiet

Die Erfindung betrifft ein Verfahren zur Erhöhung der temperaturunabhängigen Spannungsfestigkeit elektronischer Schaltungsanordnungen mit Metalloxidtransistoren nach der Gattung des Hauptanspruchs, sowie von einer Schaltungsanordnung mit mindestens einem Metalloxidtransistor und einer erhöhten temperaturunabhängigen Spannungsfestigkeit nach der Gattung des Nebenanspruchs.

### Stand der Technik

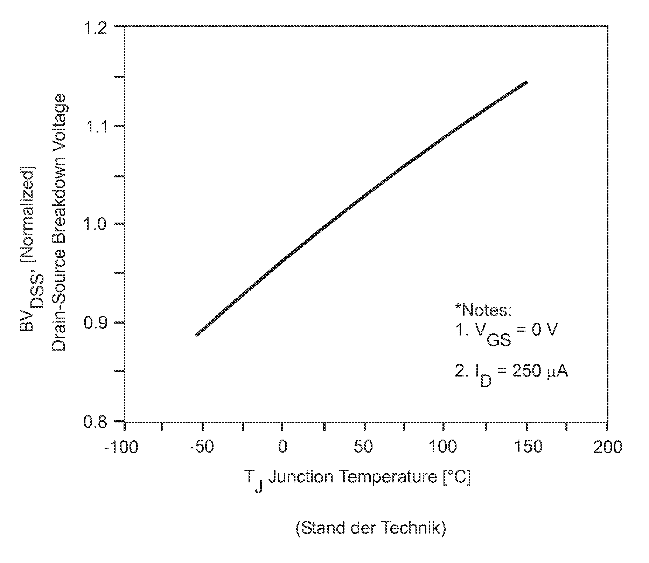

Die einzige Fig. zeigt ein Diagramm der normierten Durchbruchsspannung eines Metalloxidtransistors nach dem Stand der Technik, in der Abkürzung auch MOSFET genannt, über der Chiptemperatur aufgetragen. Es ist deutlich zu sehen, dass die Durchbruchsspannung des Metalloxidtransistors bei sinkender Temperatur des Metalloxidtransistors ebenfalls erheblich sinkt. Dies wirft das Problem auf, dass die Spannungsfestigkeit einer gesamten Schaltungsanordnung, die solch einen Metalloxidtransistor aufweist, bei niedrigen Temperaturen ebenfalls sinkt. Um dieses Problem zu umgehen sind bisher Metalloxidtransistoren mit höherer Sperrspannung verwendet worden. Diese sind jedoch erheblich teurer, und weisen Nachteile wie einen höheren Kanalwiderstand (RDS_{On}) auf. Besonders gravierend zeigt sich das Problem, wenn aufgrund der Randbedingungen Metalloxidtransistoren ausgewählt werden müssen, die einen technologiebedingten Spannungslevel überschreiten. Wird solch ein Level überschritten, kommen andere Halbleiterchips im Transistor zum Einsatz, die aufgrund einer anderen Fertigungstechnologie deutlich kostenaufwändiger sind. In solch einem Fall ist für einen Metalloxidtransistor mit höherer Sperrspannung mit erheblichen Mehrkosten zu rechnen. Alternativ kann für die Schaltungsanordnung ein engerer Temperaturbereich spezifiziert werden. Dies ist aber aufgrund der Anwendung oftmals nicht möglich.

### Aufgabe

Es ist Aufgabe der Erfindung, ein Verfahren zur Erhöhung der Spannungsfestigkeit einer elektronischen Schaltungsanordnung bei niedrigen Temperaturen anzugeben, wobei die Schaltungsanordnung mindestens einen Metalloxidtransistor aufweist, und auf die Auswahl eines Metalloxidtransistors mit höherer Sperrspannung verzichtet werden kann.

Es ist ebenfalls Aufgabe der Erfindung, eine Schaltungsanordnung mit einer erhöhten Spannungsfestigkeit bei niedrigen Temperaturen anzugeben, wobei die Schaltungsanordnung mindestens einen Metalloxidtransistor aufweist, ohne dass der Metalloxidtransistor eine höhere Sperrspannung aufweist.

### Darstellung der Erfindung

Die Lösung der Aufgabe bezüglich des Verfahrens erfolgt erfindungsgemäß mit einem Verfahren zur Erhöhung der Spannungsfestigkeit einer elektronischen Schaltungsanordnung bei niedrigen Temperaturen, wobei die Schaltungsanordnung mindestens einen Metalloxidtransistor aufweist, und vor dem Anlegen einer Spannung, die in der Nähe der Durchbruchsspannung des Metalloxidtransistors liegt, dieser durch geeignete Maßnahmen auf eine vorbestimmte Temperatur aufgeheizt wird.

In einer ersten Variante wird das Aufheizen des Metalloxidtransistors dabei durch einen hohen Strom durch den Metalloxidtransistor erreicht. In einer weiteren Variante wird das Aufheizen des Metalloxidtransistors durch eine Erhöhung der Schaltverluste des Metalloxidtransistors bewerkstelligt. In einer dritten Variante wird das Aufheizen des Metalloxidtransistors durch einen kurzzeitigen linearen Betrieb des Metalloxidtransistors bewerkstelligt. Diese Varianten stellen ein schnelles und zuverlässiges Aufheizen des Metalloxidtransistors sicher.

Das Aufheizen kann dabei entweder zeitgesteuert oder temperaturgesteuert erfolgen. Die Zeitgesteuerte Variante heizt den Metalloxidtransistor für eine vorbestimmte Zeit auf. Sie bietet den Vorteil einer kostengünstigen Implementierung. Die temperaturgesteuerte Variante misst die Temperatur der Schaltungsanordnung oder des Metalloxidtransistors und heizt ihn auf eine vorbestimmte Temperatur (z.B. 25°C) auf. Sie bietet den Vorteil einer guten Temperaturregelung des Metalloxidtransistors.

Das Aufheizen wird dabei vorzugsweise nur bei niedrigen Temperaturen der Schaltungsanordnung beziehungsweise des Metalloxidtransistors bewerkstelligt. Dies verhindert eine Überhitzung des Metalloxidtransistors bei höheren Temperaturen der Schaltungsanordnung beziehungsweise des Metalloxidtransistors.

Die Lösung der Aufgabe bezüglich der Schaltungsanordnung erfolgt erfindungsgemäß mit einer Schaltungsanordnung mit einer erhöhten Spannungsfestigkeit bei niedrigen Temperaturen, wobei die Schaltungsanordnung mindestens einen Metalloxidtransistor aufweist, und sie Mittel zum Aufheizen des Metalloxidtransistors aufweist, bevor sie eine Spannung, die in der Nähe der Sperrspannung des Metalloxidtransistors liegt, an ihn anlegt.

In einer ersten Variante wird das Aufheizen des Metalloxidtransistors dabei durch einen hohen Strom durch den Metalloxidtransistor erreicht. In einer weiteren Variante wird das Aufheizen des Metalloxidtransistors durch eine Erhöhung der Schaltverluste des Metalloxidtransistors bewerkstelligt. In einer dritten Variante wird das Aufheizen des Metalloxidtransistors durch einen kurzzeitigen linearen Betrieb des Metalloxidtransistors bewerkstelligt. Diese Varianten stellen ein schnelles und zuverlässiges Aufheizen des Metalloxidtransistors sicher. Sie können je nach Anwendung und Bedarf beliebig kombiniert werden.

Die Schaltungsanordnung heizt dabei vorzugsweise nur bei niedrigen Temperaturen der Schaltungsanordnung beziehungsweise des Metalloxidtransistors diesen auf. Dies verhindert eine Überhitzung des Metalloxidtransistors bei höheren Temperaturen der Schaltungsanordnung beziehungsweise des Metalloxidtransistors.

Das Aufheizen kann dabei entweder Zeitgesteuert oder Temperaturgesteuert erfolgen. Die Zeitgesteuerte Variante bietet den Vorteil einer kostengünstigen Implementierung. Die temperaturgesteuerte Variante bietet den Vorteil einer genauen Temperaturregelung des Metalloxidtransistors. Dabei misst die Schaltungsanordnung vorzugsweise die Temperatur des Metalloxidtransistors. Besonders bevorzugt wird die Temperatur des Metalloxidtransistors über seinen Kanalwiderstand gemessen. Dies bietet den Vorteil einer einfachen und kostengünstigen Implementierung der Temperaturmessung.

Die Schaltungsanordnung ist vorzugsweise dafür ausgelegt, mindestens eine Gasentladungslampe zu betreiben, wobei sie eine Zwischenkreisspannung zum Anlegen an den Metalloxidtransistor generiert, und den Metalloxidtransistor kurz vor dem Start der Gasentladungslampe oder beim Start der Gasentladungslampe aufheizt. Kurz vor dem Start bedeutet in diesem Fall, dass die Schaltungsanordnung die Zeit vor dem Lampenstart, in der sie die Zündspannung aufbaut, für das Aufheizen des Metalloxidtransistors nutzt. Die Zwischenkreisspannung ist während der Aufheizphase vorteilhafterweise abgesenkt, und die Aufheizphase zwischen 1s und 120s lang. Durch das Absenken der Zwischenkreisspannung wird der Metalloxidtransistor geschützt, und die Länge der Aufheizphase garantiert eine wirkungsvolle Aufheizung des Transistors. Das Absenken der Zwischenkreisspannung wird bevorzugt durch einen Gleichspannungswandler bewerkstelligt, der eine einstellbare Ausgangsspannung aufweist, und dessen Ausgangsspannung die Zwischenkreisspannung ist. Da ein Gleichspannungswandler in vielen Fällen auch aus anderen Gründen eingesetzt wird, ist es von Vorteil, diesen schon vorhandenen Gleichspannungswandler mit geringem Aufwand in seiner Ausgangsspannung einstellbar zu gestalten, um die Zwischenkreisspannung einstellen zu können.

Weitere vorteilhafte Weiterbildungen und Ausgestaltungen des erfindungsgemäßen Verfahrens und der erfindungsgemäßen Schaltungsanordnung ergeben sich aus weiteren abhängigen Ansprüchen und aus der folgenden Beschreibung.

### Kurze Beschreibung der Zeichnung(en)

Weitere Vorteile, Merkmale und Einzelheiten der Erfindung ergeben sich anhand der nachfolgenden Beschreibung von Ausführungsbeispielen sowie anhand der Zeichnung. Dabei zeigen:
Fig. Ein Diagramm der normierten Durchbruchsspannung eines Metalloxidtransistors nach dem Stand der Technik, über der Chiptemperatur aufgetragen.

### Bevorzugte Ausführung der Erfindung

Durch eine intelligente Steuerung der Schaltungsanordnung, die einen Metalloxidtransistor aufweist, kann ein Metalloxidtransistor verwendet werden, der keine erhöhte Sperrspannung aufweist. Erfindungsgemäß wird vor einem Anlegen einer Spannung an den Metalloxidtransistor, die im Bereich der Sperrspannung des Metalloxidtransistors liegt dieser auf eine Temperatur aufgeheizt, bei der er die anzulegende Spannung sicher Sperren kann. Es wird also die Temperaturabhängigkeit der Sperrspannung von Metalloxidtransistoren ausgenutzt.

In einer bevorzugten Ausführungsform wird der Metalloxidtransistor als Schalttransistor im Wechselrichter eines elektronischen Betriebsgerätes für Gasentladungslampen verwendet. Dem Wechselrichter ist oft ein Gleichspannungswandler vorgeschaltet, der z.B. eine Leistungsfaktorkorrektur ausführen kann. Der Gleichspannungswandler kann z.B. als Boost, Sepic oder Flyback Wandler ausgebildet sein. Der Gleichspannungswandler erzeugt eine geregelte Ausgangsspannung, die in den Wechselrichter eingegeben wird. Diese Spannung wird oft als Zwischenkreisspannung bezeichnet. Der Wechselrichter kann als Class-E Wandler, als Halbbrückenwechselrichter oder als Vollbrückenwechselrichter ausgeführt sein. Dementsprechend weist der Wechselrichter zwischen einem und vier Metalloxidtransistoren auf. In einem solchen Betriebsgerät werden diese Metalloxidtransistoren im kontinuierlichen Lampenbetrieb oft nahe der Sperrspannung betrieben. Die Lampenspannung der zu betreibenden Gasentladungslampe befindet sich also im Bereich der Sperrspannung des Metalloxidtransistors. Damit das elektronische Betriebsgerät auch für Außenanwendungen bei niedrigen Umgebungstemperaturen von z.B. -40°C oder aber auch Anwendungen in Kühlhäusern spezifiziert werden kann, die dann eine entsprechend niedrige Temperatur der Schaltungsanordnung beziehungsweise des Metalloxidtransistors nach sich ziehen, ist es notwendig, den beziehungsweise die Metalloxidtransistoren entsprechend vorzuheizen, damit sie die nach dem Start schnell steigende Lampenspannung der Gasentladungslampe sperren können. Die Zeitdauer, in der der Metalloxidtransistor vorgeheizt wird, und in der daher die an den Transistor angelegte Spannung, z.B. die Zwischenkreisspannung, abgesenkt ist, beträgt zwischen 1s und 120s.

Der Metalloxidtransistor kann mittels verschiedener Verfahren aufgeheizt werden. Viele Betriebsgeräte zünden die Hochdruckentladungslampen mittels einer Resonanzzündung, ähnlich wie das bei Niederdruckentladungslampen der Fall ist. Während dieser Resonanzphase fließt ein hoher Strom durch den Metalloxidtransistor, der ihn schnell und zuverlässig aufheizen kann. Zum Optimieren der Aufheizung kann der Metalloxidtransistor während einer kurzen Zeitspanne während der Resonanzzündung im linearen Bereich betrieben werden, um der Wärmeeintrag in den Transistor zu beschleunigen. Diese kurze Zeitspanne, während der der Metalloxidtransistor einen höheren Durchlaßwiderstand (R_{DSOn}) aufweist, währenddessen also die Resonanz bedämpft ist, ist für den Benutzer nicht wahrnehmbar.

Eine andere Variante ist es, den Metalloxidtransistor während der Aufheizphase der Hochdruckentladungslampe aufzuheizen. Eine Hochdruckentladungslampe hat kurz nach der Zündung noch eine recht niedrige Lampenspannung, die während des Hochlaufens der Lampe stetig steigt. In dieser Zeit kann der Metalloxidtransistor ebenfalls noch aufgeheizt werden, ohne Gefahr zu laufen, durch Überspannung zerstört zu werden. Das Aufheizen erfolgt wieder durch erhöhte Schaltverluste während der Aufheizphase. Die erhöhten Schaltverluste können z.B. durch einen kapazitiven Betrieb des Metalloxidtransistors entstehen, oder durch eine Erhöhung der Schaltfrequenz, wodurch sich die Verluste Pro Zeiteinheit erhöhen. Die Erhöhung der Schaltfrequenz bietet den Vorteil, dass dadurch die durch den Metalloxidtransistor geschaltete Spannung erniedrigt werden kann, ohne dass ein Verlöschen des Lichtbogens befürchtet werden muss. Bei hocheffizienten Wandlerstrategien, die ein Spannungsfreies Schalten (ZVS) des Metalloxidtransistors oder ein Stromfreies Schalten (ZCS) des Metalloxidtransistors implementiert haben, besteht die Möglichkeit diese Schaltmimik vorübergehend abzustellen, um so erhöhte Schaltverluste zu generieren und den Metalloxidtransistor schnell aufzuheizen. Natürlich kann auch hier der Transistor so angesteuert werden, dass er für kurze Zeit im linearen Betrieb arbeitet, um die Schaltverluste weiter zu erhöhen, und den Transistor weiter aufzuheizen.

Bei einer weiteren Ausführungsform sind beide Möglichkeiten kombiniert, und der Transistor wird während der Zündung der Hochdruckentladungslampe und auch während des Hochlaufens der Hochdruckentladungslampe aufgeheizt.

Bei einer Schaltungsanordnung, die einen Gleichspannungswandler aufweist, kann während dieser Hochlaufphase die Zwischenkreisspannung vom Gleichspannungswandler abgesenkt werden, da wie oben schon erwähnt die Lampenspannung entsprechend niedrig ist. Dadurch ist sichergestellt, dass der Metalloxidtransistor die an ihn angelegte Spannung sicher sperren kann.

Eine Möglichkeit zur Steuerung der Heizphasen ist die Messung der Metalloxidtransistortemperatur. Dies kann durch einen am Metalloxidtransistor angebrachten Temperaturfühler oder mittels des Bahnwiderstandes des Metalloxidtransistors geschehen. Der Bahnwiderstand kann mittels einer temperaturkompensierten Messanordnung gemessen, und so die Chiptemperatur des Metalloxidtransistors bestimmt werden. Die Heizphasen werden dann solange gesteuert, bis der Transistor eine vorbestimmte Mindesttemperatur (z.B. +25°C) erreicht hat.

Eine einfachere Möglichkeit besteht darin, dass die Heizphasen des Metalloxidtransistors zeitgesteuert an ihn angelegt werden. Diese Variante ist einfacher in der Realisierung, birgt aber den Nachteil dass der Transistor beim Start einer schon warmen Schaltung zu sehr erhitzt wird.

Bei bestimmten Anwendungen und bestimmten Betriebszuständen (z.B. gedimmter Betrieb einer Hochdruckentladungslampe in einem Kühlhaus) kann es vorkommen, dass der Metalloxidtransistor unter eine vorbestimmte Temperatur fällt. Dann sind auch im Normalbetrieb zusätzliche Heizphasen vorzusehen, um einen sicheren Betrieb des Metalloxidtransistors zu gewährleisten. Die Heizphasen können nach obiger Beschreibung in den Betrieb der Hochdruckentladungslampe implementiert werden. In diesem Zusammenhang ist ein Linearbetrieb des Metalloxidtransistors und/oder ein vorübergehendes Ausschalten des Spannungsfreien Schaltens (ZVS) des Metalloxidtransistors oder des Stromfreien Schaltens (ZCS) des Metalloxidtransistors den anderen beschriebenen Verfahren vorzuziehen.

## Patentansprüche

1. Verfahren zur Erhöhung der Spannungsfestigkeit einer elektronischen Schaltungsanordnung bei niedrigen Temperaturen, wobei die Schaltungsanordnung mindestens einen Metalloxidtransistor aufweist, **dadurch gekennzeichnet, dass** der Metalloxidtransistor vor dem Anlegen einer Spannung, die in der Nähe seiner Durchbruchsspannung liegt, aufgeheizt wird.

2. Verfahren nach Anspruch 1, **dadurch gekennzeichnet, dass** das Aufheizen des Metalloxidtransistors durch einen hohen Strom durch den Metalloxidtransistor und/oder durch eine Erhöhung der Schaltverluste des Metalloxidtransistors und/oder durch einen kurzzeitigen linearen Betrieb des Metalloxidtransistors erreicht wird.

3. Verfahren nach einem der vorhergehenden Ansprüche, **dadurch gekennzeichnet, dass** das Aufheizen entweder zeitgesteuert oder temperaturgesteuert erfolgt.

4. Verfahren nach einem der vorhergehenden Ansprüche, **dadurch gekennzeichnet, dass** das Aufheizen des Metalloxidtransistors nur bei niederen Temperaturen der Schaltungsanordnung bewerkstelligt wird.

5. Schaltungsanordnung mit einer erhöhten Spannungsfestigkeit bei niedrigen Temperaturen, wobei die Schaltungsanordnung mindestens einen Metalloxidtransistor aufweist, **dadurch gekennzeichnet, dass** die Schaltungsanordnung Mittel zum Aufheizen des mindestens einen Metalloxidtransistors aufweist, bevor sie eine Spannung, die in der Nähe der Sperrspannung des Metalloxidtransistors liegt, an ihn anlegt.

6. Schaltungsanordnung nach Anspruch 5, **dadurch gekennzeichnet, dass** sie Mittel zum Aufheizen des Metalloxidtransistors durch einen hohen Strom durch den Metalloxidtransistor und/oder durch eine Erhöhung der Schaltverluste des Metalloxidtransistors und/oder durch einen kurzzeitigen linearen Betrieb des Metalloxidtransistors aufweist

7. Schaltungsanordnung nach einem der vorhergehenden Ansprüche, **dadurch gekennzeichnet, dass** sie Mittel zum Aufheizen des Metalloxidtransistors durch eine Zeitsteuerung oder durch eine Temperatursteuerung aufweist.

8. Schaltungsanordnung nach einem der vorhergehenden Ansprüche, **dadurch gekennzeichnet, dass** sie den Metalloxidtransistor nur bei niederen Temperaturen der Schaltungsanordnung oder des Metalloxidtransistors aufheizt.

9. Schaltungsanordnung nach Anspruch 11, **dadurch gekennzeichnet, dass** sie die Temperatur des Metalloxidtransistors misst.

10. Schaltungsanordnung nach Anspruch 12, **dadurch gekennzeichnet, dass** sie die Temperatur des Metalloxidtransistors über seinen Kanalwiderstand misst.

11. Schaltungsanordnung nach einem der vorhergehenden Ansprüche, **dadurch gekennzeichnet, dass** die Schaltungsanordnung geeignet ist, mindestens eine Gasentladungslampe zu betreiben, wobei sie eine Zwischenkreisspannung zum Anlegen an den Metalloxidtransistor generiert, und den Metalloxidtransistor kurz vor dem Start der Gasentladungslampe oder beim Start der Gasentladungslampe aufheizt.

12. Schaltungsanordnung nach Anspruch 13, **dadurch gekennzeichnet, dass** sie Mittel zum Absenken der Zwischenkreisspannung während der Aufheizphase aufweist, und die Aufheizphase zwischen 1s und 120s lang ist.

13. Schaltungsanordnung nach Anspruch 11 oder 12, **dadurch gekennzeichnet, dass** sie einen Gleichspannungswandler mit einer einstellbaren Ausgangsspannung zum Absenken der Zwischenkreisspannung aufweist, wobei die Ausgangsspannung des Gleichspannungswandlers die Zwischenkreisspannung ist.
